# FASCICULE DE BREVET EUROPEEN

(11) **EP 1 932 121 B1**
(45) Date de publication et mention de la délivrance du brevet: **06.05.2009**
(21) Numéro de dépôt: 06806980.6
(22) Date de dépôt: 04.10.2006
(51) Int. Cl.: G07F 7/00

(54) **COMPTEUR D'EVENEMENTS**
EREIGNIS-ZÄHLER
EVENT COUNTER

(30) Priorité: 05.10.2005 FR 0553012
(43) Date de publication de la demande: 18.06.2008
(73) Titulaire: PROTON WORLD INTERNATIONAL N.V., 1930 ZAVENTEM (BE)
(72) Inventeur: VAN ASSCHE, Gilles, B-1030 Bruxelles (BE); MODAVE, Jean-Louis, B-1340 Ottignies (BE)
(74) Mandataire: de Beaumont, Michel
(86) Numéro de dépôt international: PCT/EP2006/067046
(87) Numéro de publication internationale: WO 2007/039629

(56) Documents cités:
- WO-A-98/29813
- US-A- 6 023 771
- US-B1- 6 507 916

## Description

### Domaine de l'invention

La présente invention concerne de façon générale les compteurs électroniques et, plus particulièrement, les compteurs réalisés au moyen d'un ensemble de cellules mémoire dont les états respectifs conditionnent la valeur du compteur.

La présente invention s'applique plus particulièrement à des compteurs dits d'événements qui sont utilisés pour compter le nombre d'occurrences d'un événement particulier (par exemple l'exécution d'une étape donnée d'un programme) et dont la valeur est exploitée par rapport à un ou plusieurs seuils. Il peut s'agir, par exemple, de compteurs kilométriques de véhicules automobiles.

### Exposé de l'art antérieur

Les compteurs d'événements, notamment dans des applications dites sécuritaires où l'on souhaite par exemple surveiller l'exécution correcte d'un programme ou le nombre d'occurrences d'une opération donnée, exploitent généralement une mémoire non volatile pour stocker la valeur courante du compteur. Il s'agit, par exemple, d'une mémoire EEPROM dont les cellules sont mises à jour à chaque incrémentation ou décrémentation du compteur.

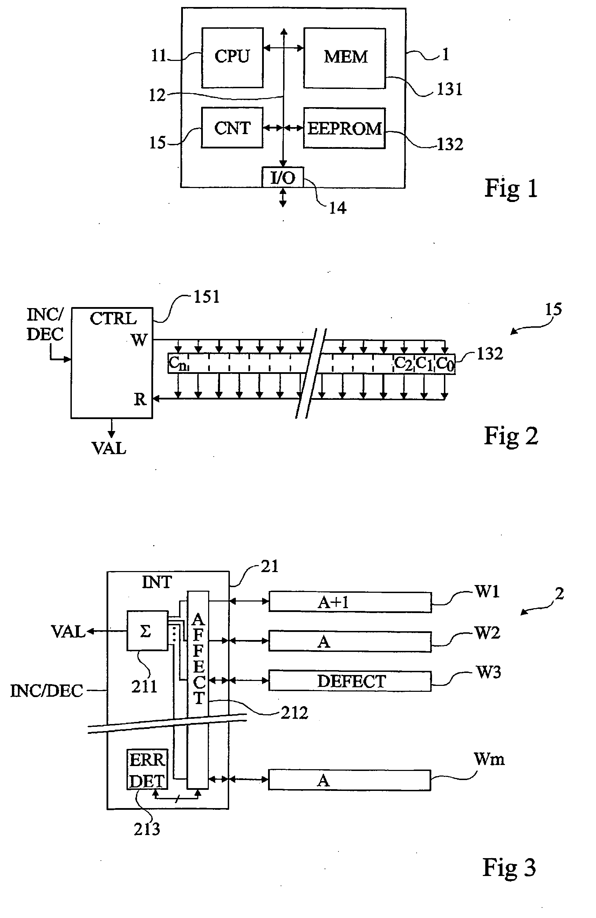

La figure 1 représente, de façon très schématique et sous forme de blocs, un exemple de processeur intégré 1 du type auquel s'applique la présente invention. Un tel circuit intégré 1 comporte une unité centrale de traitement 11 (CPU) qui communique par l'intermédiaire d'un ou plusieurs bus 12 de données, d'adresses et de signaux de commande, avec une ou plusieurs mémoires 131 (MEM) et 132 (EEPROM) parmi lesquelles au moins une mémoire non volatile 132. Tout ou partie des bus 12 sont reliés à un circuit 14 (I/O) d'entrée/sortie pour communiquer avec l'extérieur du circuit 1. Fonctionnellement, le circuit 1 comporte au moins un compteur 15 (CNT) réalisé de façon matérielle ou logicielle et exploitant une zone de la mémoire non volatile 132 pour stocker la valeur du compteur. Le circuit 1 est, par exemple, contenu dans une carte à puce.

La figure 2 représente, de façon très schématique, un exemple classique de compteur 15 utilisant des cellules d'une mémoire. Un tel compteur utilise un ensemble 132 de cellules Ci (par exemple, n cellules, i étant compris entre 1 et n) pour stocker la valeur du compteur sur n bits. Ces cellules sont accessibles en lecture R et en écriture W par un circuit 151 de commande (CTRL) recevant une instruction INC/DEC d'incrément ou de décrément provenant, par exemple, de l'unité centrale 11 pour mettre à jour la valeur contenue dans les cellules de l'ensemble 132. Les circuits ou programmes conditionnant la mise à jour de la valeur du compteur et exploitant son résultat peuvent être de diverses natures.

Le circuit 151 fournit, suite à une lecture du contenu des cellules, la valeur VAL du compteur. Cette valeur est ensuite exploitée, par exemple, pour être comparée par rapport à un seuil afin de détecter un éventuel dépassement du compteur d'événements par un programme approprié. Dans les applications que vise plus particulièrement la présente invention, le résultat de la valeur du compteur est généralement exploité pour entamer une action particulière (par exemple, un blocage d'une carte à puce, l'émission d'un signal d'alerte, etc.) lorsque la valeur du compteur atteint un seuil dit de sécurité. Cette valeur n'a toutefois généralement pas besoin d'être précise à l'unité près pour détecter un fonctionnement considéré comme anormal dans un circuit intégré. Des exemples d'application sont la limitation du nombre de saisies d'un code confidentiel, la limitation du nombre d'utilisations d'une application, etc.

La représentation de la figure 2 est fonctionnelle et schématique. En pratique, des circuits d'adressage et de sélection des cellules dans un plan mémoire sont requis.

Un problème lié à l'utilisation des mémoires, notamment non volatiles, est que les programmations multiples des cellules de ces mémoires peuvent engendrer une usure et que des cellules deviennent défectueuses au cours de la vie du produit.

La solution actuelle pour résoudre ce problème est de prévoir des cellules dites de redondance pour remplacer des cellules devenues défectueuses. De telles cellules de redondances servent également à corriger des défauts de fabrication du produit. Un inconvénient est que plus le nombre de cellules de redondance utilisées augmente, plus le temps de mise à jour du compteur augmente. Or, dans des mémoires non volatiles, l'écriture prend plus de temps que dans d'autres mémoires.

Une difficulté est de détecter qu'une cellule est devenue inutilisable au cours de la vie du produit. Cela requiert de tester périodiquement toutes les cellules du plan mémoire. Les cellules considérées comme défectueuses sont éliminées d'un point de vue fonctionnel et ne sont plus utilisées par le circuit intégré.

Une autre difficulté est d'organiser la redondance par des mécanismes d'adressage particuliers.

Un inconvénient des techniques classiques est qu'elles conduisent à surdimensionner les plans mémoire pour la réalisation de compteurs d'événements, de façon à prévoir une redondance suffisante.

Un autre problème est le traitement de fraudes éventuelles. En effet, une cellule d'un compteur d'événement (que ce soit en mémoire volatile ou non volatile) peut devenir fonctionnellement défectueuse sous l'effet d'attaques visant à empêcher que le compteur n'atteigne le seuil à partir duquel une procédure particulière est mise en oeuvre. De telles attaques peuvent consister en des perturbations électriques, thermiques ou de rayonnement.

De telles attaques sont difficilement détectables sauf si elles reviennent à considérer la ou les cellules fournissant des résultats erronés comme défectueuses. Dans ce cas, ces cellules sont remplacées par des cellules redondantes alors qu'elles seraient susceptibles de fonctionner correctement par la suite (une fois la perturbation disparue). Cela consomme inutilement des cellules de redondance.

Le document WO 98/29813 A décrit un procédé de sécurisation d'un module de sécurité destiné à coopérer avec un dispositif de traitement de l'information, le module étant agencé pour exécuter un ensemble d'opérations incluants au moins une opération sensible. Ce procédé comprend un compteur en circuit intégré (voir figure 1) et l'algorithme associé (voir figure 2) pour la sécurisation d'une opération sensible c'est à dire d'éviter qu'une interruption de l'opération sensible en cours d'exécution ne se produise. Le document décrit que "dans le cas ou l'on souhaite sécuriser plusieurs opérations sensibles distinctes ...on pourra définir autant de compteurs ... que d'opérations".

Le document US-B1-6 507 916 décrit un système de surveillance utilisant deux processeurs pour lire les valeurs de deux compteurs incrémentés par deux rythmes d'horloges indépendants (voir figure 2). L'échange des valeurs des compteurs entre les deux systèmes et la comparaison entre ces deux valeurs permet de déterminer une l'erreur lorsque le résultat de cette comparaison excède un seuil.

### Résumé de l'invention

La présente invention vise à pallier tout ou partie des inconvénients des compteurs connus.

L'invention vise plus particulièrement à proposer un compteur d'événements évitant en tout ou en partie l'utilisation de cellules de redondance au cours de la vie du produit.

L'invention vise également à proposer une solution capable de prendre en compte à la fois des cellules défectueuses et des cellules temporairement stressées par une attaque frauduleuse.

L'invention vise également à permettre une éventuelle réutilisation de cellules détectées comme étant défectueuses à un moment donné de la vie du produit.

Pour atteindre tout ou partie de ces objets ainsi que d'autres, la présente invention prévoit un procédé de comptage utilisant une zone de mémoire en circuit intégré, comportant au moins une étape de stockage de valeurs partielles dans plusieurs mots de tailles identiques de la mémoire, le résultat du comptage étant obtenu en additionnant arithmétiquement les valeurs contenues dans les différents mots.

Selon un mode de mise en oeuvre de la présente invention, le procédé comporte l'étape d'incrémenter ou décrémenter l'un des mots en le choisissant de telle sorte que tous les mots contiennent des valeurs comprises dans une plage donnée.

Selon un mode de mise en oeuvre de la présente invention, ladite plage est fixée en fonction de la tolérance souhaitée pour le résultat du compteur.

Selon un mode de misé en oeuvre de la présente invention, l'incrément ou décrément est l'unité.

Selon un mode de mise en oeuvre de la présente invention, si un mot ne contient pas l'une des valeurs de la plage, une mise à jour de ce mot vers une de ces valeurs est tentée.

La présente invention prévoit également un compteur en circuit intégré comportant une zone de mémoire pour stocker la valeur du compteur, comportant :
des moyens pour comparer des valeurs partielles contenues dans différents mots mémoire de tailles identiques par rapport à une plage de valeurs possibles ;
des moyens pour affecter à des mots dont la valeur sort de la plage, l'une des valeurs de cette plage ; et
des moyens pour sommer arithmétiquement les valeurs respectives des mots pour fournir la valeur du compteur.

Selon un mode de réalisation de la présente invention, la plage de valeurs est choisie en fonction de l'écart maximum souhaité entre les valeurs résultantes du compteur.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 qui a été décrite précédemment représente, de façon très schématique et sous forme de blocs, un exemple de processeur intégré comprenant un compteur du type auquel s'applique la présente invention ;
la figure 2 qui a été décrite précédemment représente, de façon très schématique et sous forme de blocs, un exemple classique de compteur ;
la figure 3 représente, de façon très schématique et sous forme de blocs, un mode de réalisation d'un compteur d'événements selon la présente invention ;
la figure 4 est un organigramme simplifié d'une lecture d'un compteur selon un mode de mise en oeuvre de l'invention ;
la figure 5 est un organigramme simplifié d'une mise à jour de la valeur d'un compteur selon un mode de mise en oeuvre de la présente invention ; et
la figure 6 est un organigramme simplifié d'un mécanisme de vérification du compteur selon un mode de mise en oeuvre de la présente invention.

De mêmes éléments ont été désignés par de mêmes références aux différentes figures. Pour des raisons de clarté, seuls les éléments de circuit et étapes de procédé qui sont utiles à la compréhension de l'invention ont été représentés aux figures et seront décrits par la suite. En particulier, le circuit ou programme conditionnant la mise à jour de la valeur du compteur n'a pas été détaillé, l'invention étant compatible avec tout circuit ou programme classique déclenchant un incrément ou un décrément d'un compteur d'événements. De plus, l'exploitation faite de la valeur du compteur que ce soit en elle-même ou par rapport à un seuil n'a pas été détaillée, l'invention étant là encore compatible avec toutes les exploitations classiques d'un compteur d'événements.

### Description détaillée

Une caractéristique d'un mode de réalisation de la présente invention est de diviser l'ensemble de cellules mémoire du compteur en mots de plusieurs cellules de tailles identiques et d'obtenir le résultat de la valeur du compteur par une sommation arithmétique des valeurs respectives des différents mots.

Une autre caractéristique d'un mode de réalisation de l'invention est d'organiser la mise à jour des valeurs des différents mots de telle sorte qu'elles respectent les unes par rapport aux autres un écart fixé (de préférence, l'unité). Comme on le verra par la suite, cet écart conditionne la tolérance du résultat du compteur.

Une autre caractéristique d'un mode de mise en oeuvre de la présente invention est de considérer tout mot dont la valeur ne respecte pas l'écart donné par rapport aux autres mots comme contenant une cellule fonctionnellement défectueuse, et de considérer alors, au moins en lecture, qu'il contient une des deux valeurs extrêmes de la plage de valeurs fixée par cet écart.

L'invention tire profit du fait que, dans la plupart des applications de compteurs d'événements, il n'est pas nécessaire d'être précis à un près.

La figure 3, représente, de façon très schématique et sous forme de blocs, un mode de réalisation d'un compteur d'événements 2 selon la présente invention. Ce compteur utilise plusieurs groupes ou mots de cellules mémoire W1 à Wm. Ces différents mots sont exploités par un circuit 21 d'interprétation contenant au moins une fonction 211 de sommation arithmétique (Σ) des valeurs contenues dans les différents mots. Le résultat de cette sommation fournit la valeur VAL du compteur. Le circuit 21 reçoit un signal INC/DEC d'incrément ou de décrément (provenant par exemple d'une unité centrale (11, figure 1)). Fonctionnellement, le circuit 21 comporte une fonction 212 (AFFECT) pour affecter à d'éventuels mots contenant une ou plusieurs cellules défectueuses (même temporairement), une des valeurs contenues par les autres mots valides. La détection est effectuée par un bloc 213 (ERR DET) qui balaye les différentes valeurs des mots Wi (i compris entre 1 et m) pour comparer cette valeur par rapport à une plage de valeurs conditionnée par la tolérance souhaitée par le compteur. Par exemple, pour un compteur dont le pas d'incrément et de décrément est l'unité, et dans la mesure où la mise à jour des différents mots est organisée pour que leurs contenus respectifs ne soient pas différents de plus d'une unité les uns par rapport aux autres, un mot est considéré comme défectueux si sa lecture ne fournit pas l'une des deux valeurs possibles prises par les autres mots.

Dans l'exemple de la figure 3, on suppose que les mots valides du compteur (par exemple W1, W2 et Wm dans la représentation) contiennent respectivement les valeurs A+1, A et A, où A représente un nombre entier, et que le mot W3 comporte une cellule défectueuse entraînant que la valeur DEFECT lue ne correspond ni à A ni à A+1. Le mot W3 est détecté par le circuit 213 qui compare les contenus respectifs des différents mots par rapport aux valeurs A et A+1.

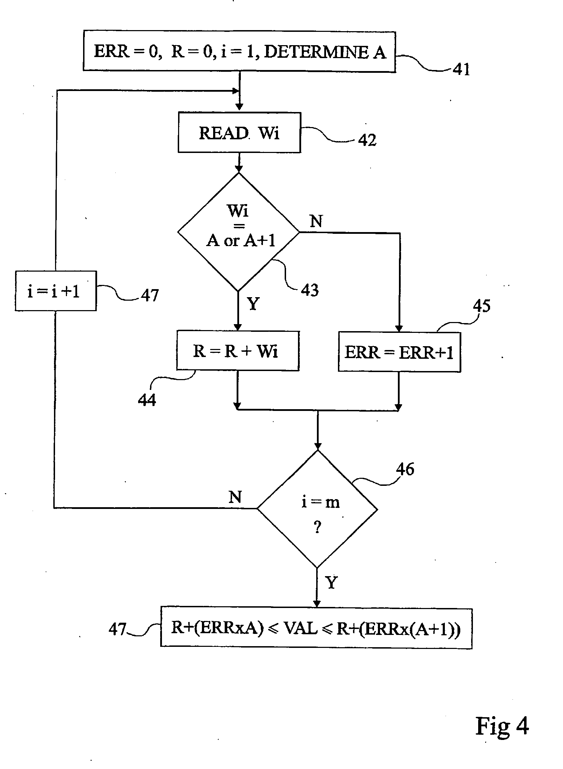

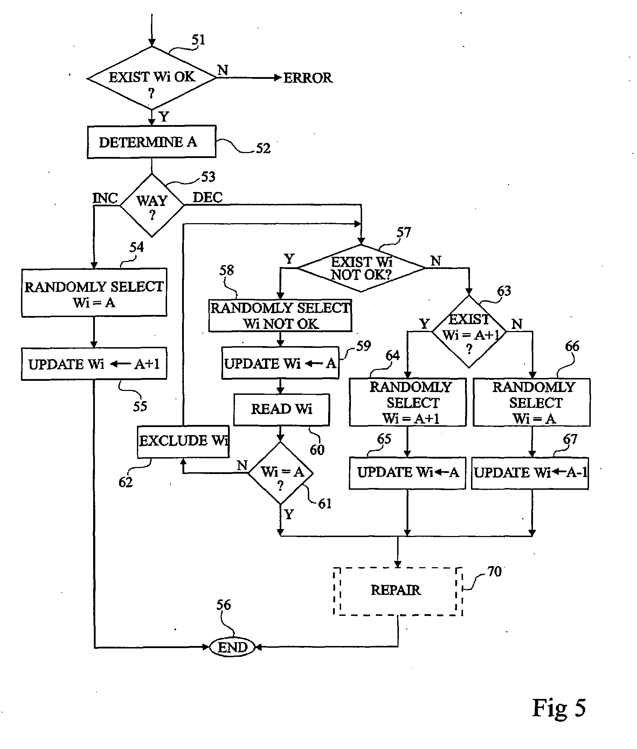

Le fait qu'un mot contienne une valeur erronée n'empêche pas sa prise en compte pour le résultat du compteur. En effet, comme cela sera mieux compris par la suite en relation avec les figures 4 et 5, selon que le résultat du compteur est exploité par rapport à une décroissance ou à une croissance du nombre d'événements, le circuit 212 affecte au mot erroné (W3 dans cet exemple), soit la valeur A soit la valeur A+1 pour en tenir compte dans la sommation 211.

Le nombre m de mots Wi conditionne la tolérance du compteur sur le résultat global fourni. En notant ERR le nombre de mots considérés comme contenant des cellules défectueuses lors d'une lecture et PAS le pas d'incrément ou de décrément du compteur, la valeur VAL représente le résultat à plus ou moins ERR*PAS.

La mise en oeuvre de l'invention requiert théoriquement un nombre de cellules mémoire supérieur à celui d'un compteur classique. En effet, pour réaliser l'équivalent d'un compteur sur n bits (comptant jusqu'à 2ⁿ ), la mise en oeuvre de l'invention requiert k*n bits, où k est une constante qui détermine le nombre de cellules défectueuses ou incomplètement mises à jour. L'économie en cellules de redondance et la simplification de la gestion des cellules défectueuses justifie en pratique cette augmentation de taille.

L' invention sera décrite par la suite avec un exemple d'un pas unitaire du compteur. On notera toutefois qu'elle s'applique plus généralement à des valeurs d'incrément ou de décréments différents de l'unité pourvu que cette valeur soit compatible avec la tolérance souhaitée sur l'évolution de la valeur globale.

La figure 4 illustre, de façon très schématique et par un organigramme simplifié, un mode de mise en oeuvre de la présente invention en lecture de la valeur d'un compteur tel que représenté en figure 3.

On commence (bloc 41, ERR=0, R=0, i=1, DETERMINE A) par initialiser la lecture en mettant à zéro la valeur d'un accumulateur R (par exemple un registre), la valeur d'un compteur de mots défectueux ERR, un index i de mot, et par déterminer la valeur A courante de certains des mots valides. Cette valeur A évolue avec l'incrémentation ou la décrémentation du compteur mais tous les mots valides contiennent soit la valeur A soit la valeur A+1. La valeur A évolue avec la vie du compteur. Si tous les mots Wi valides contiennent une même valeur, c'est cette valeur qui est considérée comme représentée par A. Si des mots valides contiennent une valeur et les autres mots valides cette valeur majorée de 1, la valeur la plus faible est considérée comme représentée par A. La détermination de la valeur A s'effectue, par exemple, en cherchant la paire de valeurs consécutives (A, A+1) la plus fréquente parmi les mots Wi et en prenant la plus petite valeur A de la paire. On peut également chercher le maximum des valeurs possibles et considérer que cette valeur est A+1. Si aucune valeur A n'existe parmi les mots Wi, on considère.alors que la valeur A est le maximum rencontré.

Une fois les initialisations terminées, on effectue plusieurs itérations d'une boucle de lecture des différents mots ayant pour objet d'accumuler leurs résultats respectifs. A chaque itération de cette boucle, on commence par lire (bloc 42, READ Wi) la valeur contenue par le mot Wi. On vérifie alors (bloc 43, Wi=A OR A+1) que cette valeur est contenue dans la plage autorisée fixée par la valeur A courante. Dans l'affirmative (sortie Y du bloc 43), la valeur A ou A+1 contenue dans le mot Wi est ajoutée au registre résultat R (bloc 44, R=R+Wi). Dans la négative (sortie N du bloc 43) le compteur de mot erroné ERR est incrémenté (bloc 45, ERR=ERR+1). Ce compteur est, par exemple, contenu dans un registre.

Tant que le nombre total m de mots n'a pas été lu (bloc 46, i=m ?), l'index de mot i est incrémenté (bloc 47, i=i+1) et on revient à l'étape de lecture 42. Une fois que tous les mots Wi ont été balayés (sortie Y du bloc 46), la valeur VAL du compteur est donnée comme étant comprise entre R+(ERR*A) et R+ (ERR* (A+1 ) ).

En variante, le résultat (bloc 47) de la valeur VAL est directement estimé en fixant pour les mots contenant une cellule défectueuse un incrément de A ou A+1 selon que l'on souhaite surveiller un dépassement de seuil vers le haut ou vers le bas du compteur. Dans ce cas, le compteur ERR peut être omis et l'étape 45 est remplacée par une étape d'ajout de la valeur A ou A+1 au registre résultat R.

En pratique, l'interprétation des mots du compteur peut être effectuée en parallèle ou successivement avec des moyens matériels et/ou logiciels.

La figure 5 représente, sous forme d'organigramme simplifié, un mode de mise en oeuvre du procédé de l'invention pour la mise à jour en incrément ou en décrément d'un compteur tel qu'illustré par la figure 3.

On commence (bloc 51, EXIST Wi OK ?) par s'assurer qu'il existe un mot non défectueux (qu'il existe au moins un mot lisible).

Dans la négative (sortie N du bloc 51), on met en oeuvre un traitement d'erreur (ERROR), le compteur étant inutilisable.

Dans l'affirmative (sortie Y du bloc 51), comme pour la lecture, on détermine (bloc 52, DETERMINE A) la valeur A contenue dans les mots non défectueux.

Selon l'instruction INC/DEC reçue par le circuit 21 (bloc 53, WAY ?), le compteur doit être incrémenté ou décrémenté.

Pour un incrément (sortie INC du bloc 53), on sélectionne de façon aléatoire l'un des mots Wi du compteur contenant la valeur A (bloc 54, RANDOMLY SELECT Wi=A). Il existe forcément un tel mot à partir du moment où tous les mots ne sont pas défectueux. Ce mot est mis à jour (bloc 55, UPDATE Wi←A+1) en l'incrémentant de 1 pour qu'il contienne la valeur A+1. Le processus d'écriture est alors terminé (bloc 56 END).

Pour décrémenter le compteur (sortie DEC du bloc 53), on commence par déterminer s'il existe un mot Wi défectueux (bloc 57 EXIST Wi NOT OK ?) .

Dans l'affirmative, on sélectionne de façon aléatoire l'un des mots défectueux (bloc 58, RANDOMLY SELECT Wi NOT OK) et on cherche à le réparer en le mettant à jour vers la valeur A (bloc 59, UPDATE Wi←A). Puis, on vérifie la réparation en lisant le contenu du mot que l'on vient d'écrire (bloc 60, READ Wi) et en comparant son contenu par rapport à la valeur A (bloc 61, WI=A ?). Si le mot contient la valeur A (sortie Y du bloc 61), le processus d'écriture est alors terminé (bloc 56). Dans le cas contraire (sortie N du bloc 61), le mot est exclu (bloc 62, EXCLUDE Wi) de la plage des mots pris en compte pour l'opération courante d'écriture.

Si tous les mots sont corrects (sortie N du bloc 57), on vérifie (bloc 63, EXIST Wi=A+1) si l'un des mots contient la valeur A+1. Dans l'affirmative (sortie Y du bloc 63), on sélectionne (bloc 64, RANDOMLY SELECT Wi=A+1) l'un de ces mots pour le mettre à jour (bloc 65, UPDATE Wi←A) à la valeur A en le décrémentant. L'opération de décrément est alors terminée (bloc 56). Si aucun mot contient la valeur A+1 (sortie N du bloc 63), cela signifie que tous les mots contiennent la même valeur (A). On sélectionne aléatoirement l'un quelconque des mots (bloc 66, RANDOMLY SELECT Wi=A) que l'on met à jour (bloc 67, UPDATE Wi←A-1) vers la valeur A-1 et l'opération de décrément est terminée (bloc 56). Dans ce dernier cas, lors de la détermination suivante de la valeur A, celle-ci se trouve diminuée de 1.

De façon optionnelle (et si la durée d'exécution disponible le permet), chaque décrément du compteur s'accompagne d'une tentative de réparation de tous les mots défectueux (bloc 70, REPAIR).

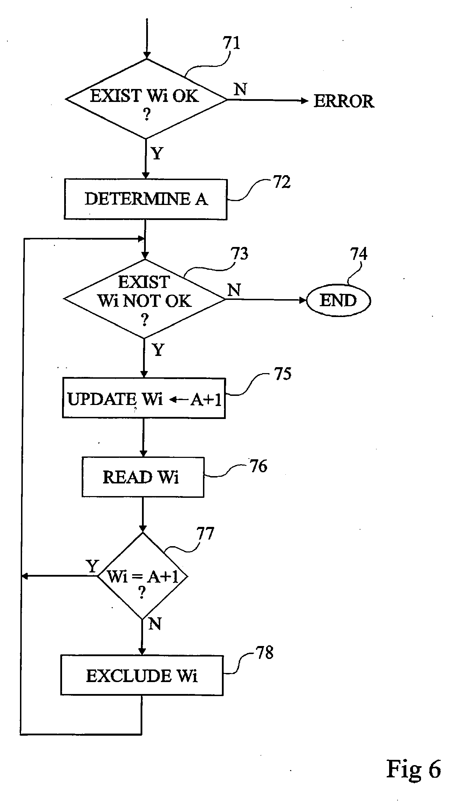

La figure 6 est un exemple d'organigramme simplifié d'un sous-programme 70 de tentative de réparation systématique des mots défectueux ou incohérents. Ce sous programme peut être exécuté, par exemple, à la fin d'une opération de décrément (figure 5) et/ou de façon périodique indépendamment des opérations sur le compteur.

On commence (bloc 71, EXIST Wi OK ?) par balayer les mots du compteur pour déterminer s'il existe au moins un mot lisible.

Dans la négative (sortie N du bloc 71), on met en oeuvre un traitement d'erreur (ERROR), le compteur étant inutilisable.

Dans l'affirmative (sortie Y du bloc 71), on détermine (bloc 72, DETERMINE A) la valeur A contenue dans les mots non défectueux.

Puis, on détermine en balayant tous les mots s'il existe un mot Wi défectueux (bloc 73, EXIST Wi NOT OK ?).

Dans la négative (sortie N du bloc 73), le sous-programme est terminé (bloc 74, END).

Dans l'affirmative (sortie Y du bloc 73), on cherche à réparer le mot défectueux trouvé en le mettant à jour vers la valeur A+1 (bloc 75, UPDATE Wi←A+1) . Puis, on vérifie la réparation en lisant le contenu du mot que l'on vient d'écrire (bloc 76, READ Wi) et en comparant son contenu par rapport à la valeur A+1 (bloc 77, WI=A+1 ?). Si le mot contient la valeur A+1 (sortie Y du bloc 77), la réparation a fonctionné et on revient en entrée du bloc 73 pour terminer le balayage des mots. Dans le cas contraire (sortie N du bloc 77), le mot courant est exclu (bloc 78, EXCLUDE Wi) de la plage des mots pris en compte pour l'opération courante d'écriture ou est remplacé par un mot redondant et on revient en entrée du bloc 73 pour terminer le balayage des mots.

Un avantage de la présente invention est que le compteur fonctionne même avec des cellules défectueuses dans la mesure où les mots contenant des cellules défectueuses sont autocompensés par ceux contenant des cellules qui marchent. Un avantage de la présente invention est qu'elle accroît en quelque sorte virtuellement la capacité de redondance de la mémoire non volatile.

Un autre avantage de la présente invention est qu'elle améliore la durée de vie des compteurs d'événements sans pour autant requérir un accroissement des cellules de redondance potentielles. L'invention reste toutefois compatible avec l'utilisation de cellules redondantes. En effet, si une cellule considérée comme défectueuse ne parvient pas à être réparée par une écriture, on peut alors mettre à oeuvre un processus classique de redondance. Dans ce cas, un avantage de l'invention est qu'il réduit le nombre de cellules de redondance requis pour une même capacité de compteur.

Un autre avantage induit par la présente invention est que le compteur d'événement est protégé contre d'éventuelles tentatives de fraude ou perturbations accidentelles.

Un autre avantage de la présente invention est qu'elle simplifie la détection d'une éventuelle cellule défectueuse en ramenant cette détection au niveau des mots.

Bien entendu, la présente invention est susceptible de diverses variantes et modifications qui apparaîtront à l'homme de l'art. En particulier, l'invention s'applique à un incrément différent de l'unité, la seule conséquence est que la tolérance du compteur se trouve accrue. L'erreur maximale correspond alors au nombre de mots du compteur multiplié par l'écart possible entre les deux valeurs extrêmes susceptibles d'être contenues dans chaque mot.

De plus, bien que l'invention ait été décrite en relation avec un exemple appliqué au cas où le résultat total du compteur est surestimé, c'est-à-dire en affectant la valeur A+1 (plus généralement la valeur supérieure de la plage de valeurs des mots considérés comme défectueux), elle s'applique bien entendu également à une sous-estimation du résultat total en affectant la valeur A (plus généralement la valeur inférieure de la plage de valeurs) aux mots considérés défectueux.

En outre, la mise en oeuvre de l'invention que ce soit par des moyens logiciels ou matériels est à la portée de l'homme du métier à partir des explications fonctionnelles données ci-dessus.

## Revendications

1. Procédé de comptage utilisant une zone de mémoire en circuit intégré (1), **caractérisé en ce qu'**il comporte au moins une étape de stockage de valeurs partielles dans plusieurs mots (Wi) de tailles identiques de la mémoire, le résultat du comptage étant obtenu en additionnant arithmétiquement (211) les valeurs contenues dans les différents mots.

2. Procédé selon la revendication 1, comportant l'étape d'incrémenter ou de décrémenter l'un des mots (Wi) en le choisissant de telle sorte que tous les mots contiennent des valeurs (A, A+1) comprises dans une plage donnée.

3. Procédé selon la revendication 2, dans lequel ladite plage est fixée en fonction de la tolérance souhaitée pour le résultat du compteur.

4. Procédé selon l'une des revendications 2 ou 3, dans lequel l'incrément ou décrément est l'unité.

5. Procédé selon l'une quelconque des revendications 1 à 4, dans lequel si un mot ne contient pas l'une des valeurs (A, A+1) de la plage, une mise à jour de ce mot vers une de ces valeurs est tentée.

6. Compteur en circuit intégré comportant une zone de mémoire pour stocker la valeur du compteur, **caractérisé en ce qu'**il comporte :
des moyens (213) pour comparer des valeurs partielles contenues dans différents mots mémoire de tailles identiques par rapport à une plage de valeurs possibles ;
des moyens (212) pour affecter à des mots dont la valeur sort de la plage, l'une des valeurs de cette plage ; et
des moyens (211) pour sommer arithmétiquement les valeurs respectives des mots (Wi) pour fournir la valeur du compteur.

7. Compteur selon la revendication 6, dans lequel la plage de valeurs est choisie en fonction de l'écart maximum souhaité entre les valeurs partielles contenues dans plusieurs mots de tailles identiques de la mémoire.

## Claims

1. A counting method using a memory area in an integrated circuit (1), **characterized in that** it comprises at least one step of storage of partial values in several memory words (Wi) of identical sizes, the result of the counting being obtained by arithmetically adding (211) the values contained in the different words.

2. The method of claim 1, comprising the step of incrementing or decrementing one of the words (Wi) by selecting it so that all the words contain values (A, A+1) present within a given range.

3. The method of claim 2, wherein said range is set according to the tolerance desired for the counter result.

4. The method of claim 2 or 3, wherein the increment or the decrement is one.

5. The method of any of claims 1 to 4, wherein, if a word does not contain one of the range values (A, A+1), an updating of this word to one of these values is attempted.

6. An integrated circuit counter comprising a memory area to store the counter value, comprising:
means (213) for comparing partial values contained in different memory words of identical sizes with respect to a range of possible values;
means (212) for assigning to words having their value outside the range one of the values of this range; and
means (211) for arithmetically summing up the respective values of the words (Wi) to provide the counter value.

7. The counter of claim 6, wherein the range of values is selected according to the maximum interval desired between the partial values contained in several memory words of identical sizes.

## Patentansprüche

1. Ein Zählverfahren unter Verwendung eines Speicherareals in einer integrierten Schaltung (1), **gekennzeichnet dadurch dass** es wenigstens aufweist den Schritt des Speicherns von partiellen Werten in mehreren Speicherworten (Wi) mit identischen Größen, wobei das Ergebnis von dem Zählen erlangt wird durch arithmetisches Addieren (211) der Werte, die in den verschiedenen Wörtern enthalten sind.

2. Verfahren nach Anspruch 1, das den Schritt aufweist des Inkrementierens oder Dekrementierens eines von den Wörtern (Wi) durch dessen Auswählen derart, dass all die Wörter Werte (A, A+1 ) enthalten und zwar präsent innerhalb eines vorgegebenen Bereichs.

3. Verfahren nach Anspruch 2, wobei der Bereich festgelegt wird gemäß der Toleranz die für das Zählergebnis gewünscht ist.

4. Verfahren nach Anspruch 2 oder 3, wobei das Inkrement oder das Dekrement Eins ist.

5. Verfahren nach irgendeinem der Ansprüche 1 bis 4, wobei, falls ein Wort nicht einen von den Bereichswerten (A, A+1 ) enthält, ein Aktualisieren von diesem Wort auf einen von diesen Werten versucht wird.

6. Eine integrierte Zählerschaltung, die ein Speicherareal aufweist zum Speichern des Zählerwertes, wobei der Zähler Folgendes aufweist:
Mittel (213) zum Vergleichen von partiellen Werten, die enthalten sind in verschiedenen Speicherwörtern mit identischen Größen mit Bezug auf einen Bereich von möglichen Werten;
Mittel (212) zum Zuweisen an Wörter deren Wert außerhalb des Bereichs ist von einem von den Werten aus diesem Bereich; und
Mittel (211 ) zum arithmetischen Aufsummieren der entsprechenden Werte von den Wörtern (Wi) zum Vorsehen des Zählerwertes.

7. Zähler nach Anspruch 6, wobei der Bereich von Werten ausgewählt wird, gemäß dem maximalen Intervall das gewünscht ist zwischen den partiellen Werten, die in mehreren Speicherwörtern von identischen Größen enthalten sind.
